# EUROPEAN PATENT SPECIFICATION

(11) **EP 2 837 032 B1**
(45) Date of publication and mention of the grant of the patent: **12.05.2021**
(21) Application number: 13716979.3
(22) Date of filing: 27.03.2013
(51) Int. Cl.: H01L 27/30, H01L 51/42

(54) **A PHOTOVOLTAIC MODULE**
Photovoltaikmodul
Module photovoltaïque

(30) Priority: 10.04.2012 US 201261622123 P; 10.04.2012 EP 12163612
(43) Date of publication of application: 18.02.2015
(73) Proprietor: InfinityPV ApS, 2800 Kgs. Lyngby (DK)
(72) Inventor: KREBS, Frederik C., DK-2800 Kgs. Lyngby (DK); SOMMER-LARSEN, Peter, DK-2630 Taastrup (DK)
(74) Representative: Inspicos P/S
(86) International application number: PCT/EP2013/056527
(87) International publication number: WO 2013/152952

(56) References cited:
- EP-A2- 1 596 446
- US-A1- 2008 223 428
- M. KALTENBRUNNER, M. S. WHITE, E.D. GLOWACKI, T. SEKITANI, T. SOMEYA, N. S. SARICIFTCI, S. BAUER: "Ultrathin and lightweight organic solar cells with high flexibility", NATURE COMMUNICATIONS, 3 April 2012 (2012-04-03), pages 1-7, XP002682520, DOI: 10.1038/ncomms1772
- HAUCH J A ET AL: "Flexible organic P3HT:PCBM bulk-heterojunction modules with more than 1 year outdoor lifetime", SOLAR ENERGY MATERIALS AND SOLAR CELLS, ELSEVIER SCIENCE PUBLISHERS, AMSTERDAM, NL, vol. 92, no. 7, 4 March 2008 (2008-03-04), pages 727-731, XP022615347, ISSN: 0927-0248, DOI: 10.1016/J.SOLMAT.2008.01.004 [retrieved on 2008-03-04]

## Description

### FIELD OF THE INVENTION

The present invention relates to a photovoltaic module comprising a printed positive and a printed negative module terminal and a plurality of printed sets of photovoltaic cell units arranged in electrical series therebetween. Each unit may comprise one photovoltaic cell or a plurality of series connected photovoltaic cells. In particular, the present invention relates to photovoltaic module which is provided on a foil of a bendable or flexible material.

### BACKGROUND OF THE INVENTION

Hitherto the most cost efficient cells have been - and still are - manufactured with crystalline silicon. In the beginning of 2012, the most efficient inorganic solar cells may convert in excess of 40 percent of the solar energy rayed onto the cell to electrical energy.

However, one huge disadvantage of such inorganic solar cells is that traditional inorganic junction based solar cells, such as those based on crystalline silicon, require large amounts of energy in their manufacture. Moreover several of the materials used in such solar cells are so rare, that it is not possible to manufacture enough solar cells to cover todays world consumption of electricity.

Today, organic foil-based photovoltaic cells are arranged electrically in parallel, whereby the electrical current generated is relatively high due to the resulting current being the sum of currents when power sources are connected in electric parallel. Typical current densities generated over the active solar cell is typically in the range of 5-15 mA cm⁻² for organic photovoltaic cells and 20-40 mA cm⁻² for inorganic solar cells. When harvesting over an area of a hundreds of square centimeters which is customary for i.e. crystalline silicon wafers a total current of several amperes is obtained. To avoid ohmic losses this will require photovoltaic cells and/or photovoltaic cell units with significant cross sections. It will be appreciated that the higher the current is, the thicker the electrical conductors interconnecting the cell units must be.

Examples of prior art arrangement may for example be found in EP 1 596 446 A2 and the following papers: "Ultrathin and lightweight organic solar cells with high flexibility" by M. Kaltenbrunner et al., Nature Communications, 3 April 2012, pages 1-7, and "Flexible organic P3HT: PCBM bulk-heterojunction modules with more than 1 year outdoor lifetime" by J A Hauch et al, Solar energy materials and solar cells, Elsevier science publishers, vol. 92, no. 7, 4 March 2008, pages 727-732.

Accordingly, there is a need for finding an alternative way of converting solar energy into electrical energy other than by using the above-mentioned highly efficient inorganic solar cells.

It may be seen as an object of one or more embodiments of the present invention to find a cost efficient solar cell which may be used to generate electrical power.

It may be seen as a further object of one or more embodiments of the present invention to find a solution where the relatively expensive conductors which are used to electrically interconnect photovoltaic cells may be replaced with inexpensive conductors or by little use of such materials.

### DESCRIPTION OF THE INVENTION

To comply with the above-mentioned objects the present invention relates, in a first aspect, to a photovoltaic module according to claim 1.

In one embodiment, each photovoltaic cell unit comprises one single photovoltaic cell. Alternatively, the photovoltaic cell unit comprises a plurality of series connected photovoltaic cells, such as two, three, four, five, six, seven, eight, nine, ten, 11, 12, 13, 14, 15, 16, 17, 18, 19, 20.

When conventional non-foil-based solar cells (i.e. solar cells based on crystalline silicon) are arranged in electrical series, the electrical characteristics of each of photovoltaic cell causes the current through the series of cells to cease if just one cell is shadowed or blocked. Moreover, overshadowing of conventional series connected voltaic cells causes two effects to occur. Firstly, a very high potential is generated over the cell, and secondly, the relatively high current will induce a charge buildup over the overshadowed cell. The two effects may induce an irreversible electrical breakdown of the non-foil-based cell. The present invention provides a solution to this problem.

It will be appreciated that in series connected conventional solar cells, the worst performing cell will dominate the current generated by the whole set of series connected. Thus, if one cell breaks down, the whole series of solar cells will no longer output an electrical current and potential over the positive and negative modules between which the series of photo voltaic cells are arranged. In traditional crystalline silicon solar cells where the cells are electrically connected in series, this problem is addressed by introducing bypass diodes. Bypass diodes alleviated the problem of module failure due to one overshadowed/blocked cell at minimum loss but also adds complexity and cost to the system.

In contrast hereto, the foil-based solar cells of the present invention have a non-ideal performance which renders a series of foil-based solar cells less vulnerable to being overshadowed.

If a foil-based cell is overshadowed or blocked, the current through the whole set of series connected cells is marginally influenced. The non-ideal diode characteristic and especially the low internal resistance prevent buildup of high potentials and charge accumulation over the overshadowed cells. This prevents irreversible electrical breakdown of the overshadowed cell. Moreover, the non-ideal diode characteristic results in the performance of the full set of foil-based cells to correspond to an average of the performance of the individual cells. Thus, one advantage of providing foil-based photo voltaic cells in electrical series is that electricity is generated even if one or more photo voltaic cells are over shadowed. It should be stressed that this is without the inclusion of bypass diodes.

Accordingly by using a less ideal technology, the vulnerability of the series connected solar cell is lower. However due to the less ideal characteristics of the cells, it is not logical for the skilled person to use such cells. This is especially true as the cells - due to their lower efficiency - will generate less electrical energy. Accordingly, in order to generate the same electrical effect, a larger amount of foil-based solar cells must be provided compared to when the conventional solar cells are used. As an example a typical polycrystalline silicone solar cell panel with standard dimensions of 1 m x 1.7 m will generate around 200 W of electrical energy. A similarly sized organic photovoltaic module (OPV module) will typically yield 10-20 W of electrical energy. In terms of area usage the current state of the art of polymer solar cells in a practical and directly comparable setting is inferior to the established crystalline silicon solar cells by a factor of 10-20 in terms of area usage.

By arranging the photovoltaic cells and/or the photovoltaic cell units in series another advantage occurs. This advantage emanates from the fact that when a plurality of power sources are arranged in series, the resulting voltage will be high (corresponding the sum of voltages of the individual power sources), while the resulting current will be low.

In the present invention the photovoltaic cell units are arranged in series whereby the electrical conductors interconnecting the cells may be thin compared to when the cells are arranged in parallel. Economically, this causes the series connected cell units to be much more inexpensive to manufacture. The benefit is obtained both in terms of materials use and simplicity in the process.

In the context of the present invention, the term 'photovoltaic module' shall be understood as a module comprising a plurality of photovoltaic cells.

In the context of the present invention, the term 'module terminal' shall be understood as an output terminal of the photovoltaic module. A photovoltaic module may comprise two module terminals e.g. a positive and a negative. In the photovoltaic module according to the present invention, the photovoltaic module comprises one positive and one negative module terminal between which the photovoltaic cell units are arranged.

In the context of the present invention, the term 'photovoltaic cell unit' shall be understood as a unit comprising one or more photovoltaic cells that each converts light that impinges on the surface and upon being absorbed is converted into electrical energy in the form of a current at a given voltage in an external circuit.

In the context of the present invention, the term 'printed' shall be understood as any kind of film forming process, such as rotary screen printing, flat bed screen printing, gravure printing, flexographic printing, inkjet printing, slot-die coating, knife coating, blade coating, bar coating and coil coating.

Each photovoltaic cell unit may comprise one or more photovoltaic cells such as one, or two, or three, or four, or five, or six, or seven, or eight, or nine, or ten, or 15, or 20, or 25, or 30 or 40 or 50.

The photovoltaic module comprises a plurality of photovoltaic cells units which are arranged in electrical series between the positive and the negative module terminals, such that any two electrically neighboring photovoltaic cells are electrically connected by an interconnecting electrical conductor. Accordingly, it will be appreciated that if N photovoltaic cell units are provided, N-2 cells are electrically connected (in series) to two neighboring cell units, while two of the cell units each is connected to one other cell unit and one module terminal. It will be appreciated that one cell unit is electrically connected to another cell units and to the positive module terminal, while another cell unit is electrically connected to another cell unit and to the negative module terminal.

In the context of the present invention, the term 'foil' shall be understood as a thin sheet of a material such as metal foil or a plastic foil. In one embodiment, the foil has a thickness which is below 1 mm, such as below 0.9 mm, such as below 0.8 mm, such as below 0.75 mm, such as below 0.7 mm, such as below 0.6 mm, such as below 0.5 mm, such as below 0.4 mm, such as below 0.3 mm, such as below 0.25 mm, such as below 0.2 mm, such as below 0.1 mm.

In the present invention, the foil is made of a bendable material and has a bend radius below 50 mm.

In the context to the present invention, the term 'bend radius' shall be understood as a minimum measure, which is measured inside a curvature, which a material can be bent without breaking, being damaged or having a shortened life. In one embodiment, the material can be bent to this radius without being plastically deformed, in other words the material is only elastically deformed when bent to this radius. Thus, it will be appreciated that the smaller the bend radius of a material is, the more flexible and bendable the material is. Similarly it will be appreciated that the larger the bend radius is, the stiffer the material is. One way of testing the bend radius of the foil is to provide a cylinder with a radius corresponding to the bend radius. Subsequently, the foil is bent about the cylinder. As an example a cylinder with a radius of 25 mm may be provided and subsequently, the foil is bent about the cylinder. Finally, the photovoltaic module may be tested so as to determine whether it is still functioning, i.e. capable of generating the same amount of electricity as a foil which has not been bent.

In one embodiment, the photovoltaic module is an organic photovoltaic module. One example of an organic photovoltaic module is a multilayer structure wherein at least one of the layers contains an organic component. Each layer in the multilayer structure may comprise an organic material, an inorganic material or a mixture thereof - hereinafter designated a hybrid material.

As an example, the structure of an organic solar cell may comprise a sandwich of five layers disposed on a substrate, e.g. by being printed or coated onto the substrate. The firstly provided layers is called layer 1, the secondly provided layer is called layer 2 etc. Layer 1 is closer carrier substrate than layer 2, which is closer to the carrier substrate than layer 3 etc. In one embodiment, layer 1 is provided directly on the foil whereby layer 1 is in direct contact with the foil.

The two outer layers (i.e. layer 1 and layer 5, which may also be designated the lowermost layer and the uppermost layer, respectively) may exclusively constitute an electrode material which may be used to extract the electrical energy from the layers therebetween (i.e. the electrical energy generated in one or more of layers 2-4). One or both of layers 1 and 5 may be semitransparent to allow light to enter one or more of the layers 2-4. Moreover, layers 1 and 5 may both be organic, one may be organic while the other is inorganic or both may be inorganic. Examples of semitransparent organic electrodes are polyaniline or poly-ethylene-3,4-dioxythiophene polystyrene sulphonate (PEDOT:PSS) and examples of inorganic electrodes are silver, aluminium and indium-tin-oxide.

In order to selectively extract electron holes (i.e. the lack of an electron at a position where one could exist in an atom or atomic lattice) and electrons at separate electrodes, two charge selective layers may be provided. Each charge selective layer may be organic or inorganic. Examples of organic layers with a selectivity towards electrons are: zinc oxide (ZnO) and titaniumdioxide (TiO₂). Electron selectivity is understood as the ability of the layer to transport electrons across it while blocking transport of electron holes. Electron hole selectivity is understood as the ability of the layer to transport electron holes across it while blocking transport of electrons. Examples of inorganic layers with a selectivity towards electron holes are: molybdenumtrioxide (MoO₃) and vandiumoxide (V₂O₅). Examples of organic layers with a selectivity towards electron holes are PEDOT:PSS and polyaniline.

The charge selective layers may be layer 2 and layer 4. The middle layer 3 may be the active layer and may comprise a mixture of an organic donor material that may be a small molecule or a polymer (i.e. poly-3-hexylthiophene, P3HT) and an acceptor material such as a fullerene material (i.e. phenyl-C61-butyric acid methyl ester, PCBM). In some embodiments, the electrode material may also function as the charge selective layer (i.e. aluminium can serve as negative electrode and electron selective layer)

In the context of the present invention, the term 'organic' shall be understood as a material that comprises molecules built through carbon-carbon bonds that may be saturated or unsaturated and that can be connected in a conjugated fashion to convey semiconducting properties. The organic materials may also include one or more other elements such as hydrogen, nitrogen, oxygen, sulphur, selenium, phosphorous and metal ions.

In one embodiment, the active layer 3 is fully or partially organic.

In one embodiment, a part of the photovoltaic module is organic. In one embodiment, any part of the photovoltaic module which is carried on the carrier substrate is organic. In another embodiment, one or more - such as all - of the positive module terminal, the negative module terminal, the photovoltaic cell units and the interconnecting electrical conductors is/are organic. In one embodiment, any part of the photovoltaic module except from the carrier substrate is organic.

It will be appreciated that as the photovoltaic cell units are connected in electrical series, the current that passes through the interconnecting electrical conductors is low compared to if the same amount of photovoltaic cells were arranged/connected in electrical parallel. This is especially true when the number of photovoltaic cells in each photovoltaic cell unit is small.

Thus, the resistance in the interconnecting electrical conductors may be larger and the dimensions of the interconnecting electrical conductors may be smaller as is described below:
With regards to the dimensions of the interconnecting electrical conductors, a height of a plurality of such as each of the interconnecting electrical conductors in a direction parallel to a normal of the foil may be below 500 µm, such as below 400 µm, such as below 300 µm, such as below 200 µm, such as below 100 µm, such as below 75 µm, such as below 50 µm, such as below 25 µm, such as below 10 µm, such as below 5 µm, such as below 1 µm, such as below 0.5 µm, such as below 0.1 µm such as below 0.05 µm. In one embodiment, the direction of the height is parallel to a normal of the carrier substrate. In one embodiment, the direction of the height is parallel to a normal of the respective electrical conductor.

Moreover with regards to the dimensions of the interconnecting electrical conductors, a length of a plurality of such as each of the interconnecting electrical conductors in a direction parallel to any of the abovementioned normals may be below 5 mm, such as below 4 mm, such as below 3 mm, such as below 2 mm, such as below 1 mm, such as below 0.5 mm, such as below 0.1 mm, such as in the range 0.1-2 mm.

Again with regards to the dimensions of the interconnecting electrical conductors, a width of a plurality of such as each of the interconnecting electrical conductors may correspond to 100 percent of the width of one or more (such as all) of the photovoltaic modules, such as 90 percent of the width of one or more (such as all) of the photovoltaic modules, such as 80 percent of the width of one or more (such as all) of the photovoltaic modules, such as 70 percent of the width of one or more (such as all) of the photovoltaic modules, such as 60 percent of the width of one or more (such as all) of the photovoltaic modules, such as 50 percent of the width of one or more (such as all) of the photovoltaic modules, such as 40 percent of the width of one or more (such as all) of the photovoltaic modules, such as 30 percent of the width of one or more (such as all) of the photovoltaic modules, such as 20 percent of the width of one or more (such as all) of the photovoltaic modules, such as 10 percent of the width of one or more (such as all) of the photovoltaic modules.

Moreover with regards to the dimensions of the interconnecting electrical conductors, a cross-sectional area of each of the interconnecting electrical conductors in a direction transverse to a longitudinal direction of the interconnecting electrical conductor may be below 1 mm², such as below 0.50 mm², such as below 0.25 mm², such as below 0.10 mm², such as below 0.05 mm², such as below 0.04 mm², such as below 0.03 mm², such as below 0.02 mm², such as below 0.01 mm², such as below 0.001 mm², such as below 0.0001 mm²

As mentioned above, the resistance of the interconnecting electrical conductors may be higher when the photovoltaic cell units are coupled in electrical series. Thus in one embodiment, the resistance of each of the interconnecting electrical conductors is above 0.25 ohms, such as above 0.50 ohms, such as above 0.75 ohms, such as above 1 ohm, such as above 1.25 ohms, such as above 1.5 ohms, such as above 1.75 ohms, such as above 2.00 ohms, such as above 2.5 ohms, such as above 3.0, such as above 3.5 ohms, such as above 4.0 ohms, such as above 4.5 ohms, such as above 5.0 ohms, such as above 6.0 ohms, such as above 7.0 ohms, such as above 8 ohms, such as above 9 ohms, such as above 10 ohms.

In one embodiment, the plurality of photovoltaic cell units comprises at least 10 photovoltaic cell units, such as at least 100 photovoltaic cell units, such as at least 500 photovoltaic cell units, such as at least 1,000 photovoltaic cell units, such as at least 5,000 photovoltaic cell units, such as at least 10,000 photovoltaic cell units, such as at least 50,000 photovoltaic cell units, such as at least 100,000 photovoltaic cell units, such as at least 1,000,000 photovoltaic cell units, such as at least 10,000,000 photovoltaic cell units, such as at least 100,000,000 photovoltaic cell units, such as at least 1,000,000,000 photovoltaic cell units.

In one embodiment, the plurality of photovoltaic cell units is capable of generating 10 Megavolts at the maximum power point, such as 100 Megavolts at the maximum power point, such as 1 Gigavolts at the maximum power point, such as 10 Gigavolts at the maximum power point, such as 100 Gigavolts at the maximum power point, such as 1 Teravolts at the maximum power point, such as 10 Teravolts at the maximum power point, such as 100 Teravolts at the maximum power point, such as 1 Petavolts at the maximum power point, such as 10 Petavolts at the maximum power point, such as 100 Petavolts at the maximum power point.

In one embodiment, each photovoltaic cell unit is adapted to generate an electrical current below 5 Ampere, such as below 4 Ampere, such as below 3 Ampere, such as below 2 Ampere, such as below 1 Ampere, such as below 750 mA, such as below 500 mA.

In one embodiment, each photovoltaic cell unit is adapted to generate an electrical potential above 0.25 volts, such as above 0.30 volts, such as above 0.40 volts, such as above 0.50 volts, such as above 0.6 volts, such as above 0.7 volts, such as above 0.8 volts, such as above 0.9 volts, such as above 1.0 volt. It will be appreciated that by arranging the photovoltaic cell units in series, the electrical current generated will be small relative to the electrical voltage generated. This is especially true when the number of photovoltaic cells in each photovoltaic cell unit is small.

In one embodiment, a maximum voltage/current-ratio corresponding to:
- a maximum voltage which may be generated by means of the photovoltaic module, divided by
- a maximum current which may be generated by means of the photovoltaic module,
is above 500 V/A, such as above 1000 V/A, such as above 5000 V/A, such as above 10000 V/A, such as above 50000 V/A, such as above 100000 V/A, such as above 500000 V/A, such as above 1000000 V/A.

In the context of the present invention, the term 'maximum voltage which may be generated by means of the photovoltaic module' shall be understood as the maximum voltage which may be generated independently of which current is generated at the same time. Accordingly, the current may be zero when the maximum voltage is generated by means of the photovoltaic module.

Similarly in the context of the present invention, the term 'maximum current which may be generated by means of the photovoltaic module' shall be understood as the maximum current which may be generated independently of which voltage is generated at the same time. Accordingly, the voltage may be zero when the maximum current is generated by means of the photovoltaic module.

In an alternative or supplement embodiment, the maximum power point voltage/current-ratio corresponds to (at a maximum power point of the solar cell)
- a voltage at the maximum power point of the solar cell, divided by
- a current at the maximum power point of the solar cell,
is above 500 V/A, such as above 1000 V/A, such as above 5000 V/A, such as above 10000 V/A, such as above 50000 V/A, such as above 100000 V/A, such as above 500000 V/A, such as above 1000000 V/A.

In the context of the present invention, the term 'maximum power point' shall be understood as the point of a photovoltaic cell/unit/module, where the values of the current (I) and Voltage (V) of the cell result in a maximum power output. These values correspond to a particular load resistance, which is equal to V/I (as specified by Ohm's Law). The power P is given by P=V^{∗}I. A photovoltaic cell has an approximately exponential relationship between current and voltage. From basic circuit theory, the power delivered from or to a device is optimized where the derivative dI/dV of the I-V curve is equal and opposite the I/V ratio (where dP/dV=0).

In one embodiment, the number of photovoltaic cells per square meter is above 200, such as above 300, such as above 400, such as above 500, such as above 1,000, such as above 1,500, such as above 2,000, such as above 2,500, such as above 3,000, such as above 3,500, such as above 4,000, such as above 5,000, such as above 6,000, such as above 7,000, such as above 8,000, such as above 9,000, such as above 10,000.

In a third aspect the present invention relates to a method for manufacturing an organic photovoltaic module according to claim 13.

The above-mentioned definitions also apply in relation to the third aspect of the present invention. It is advantageous of the method of the third aspect of the present invention that all steps of manufacturing may be performed as part of a fully automated manufacturing process requiring no hand-made or manual manufacturing processes. Thus, a roll of foil enters one end of a production line whereas in the other end of the production line a complete organic photovoltaic module is provided on another roll of foil.

### EXAMPLES

In order to determine the effect of organic polymer-based solar cells being overshadowed relative to conventional solar cells, the inventors have carried out several experiments, one of which is disclosed below.

160 organic polymer solar cells provided on a polymer foil were illuminated under a uniform source of light (1000 W m⁻², AM1.5G). The polymer solar cells comprised 10 photovoltaic cell units each comprising 16 photovoltaic cells. As the 16 solar cells were also connected in series, all 160 solar cells were electrically connected in series.

The solar cell comprised a 130 micron thick polyester substrate carrying the solar cell with the following device geometries.

In one example, the solar cell was comprised of 5 layers having a first electrode (ITO) an electron transporting layer (ZnO) the active layer (P3HT: PCBM), a hole transport layer (PEDOT: PSS) and a back electrode (screen printed silver). It is understood that ITO is the transparent conductor indium-tin-oxide, ZnO is zinc oxide, P3HT is regioregular poly-3-hexylthiophene and PCBM is phenyl-C61-butyric acid methyl ester transparent, PEDOT:PSS is poly-3,4-ethylenedioxythiophene:polystyrenesulphonate and screen printed silver as a printing formulation comprising metallic silver particles and a binding agent.

In another example similar devices were prepared without ITO and having a separate PEDOT: PSS layer to replace ITO as the first electrode. The typical cell voltages were in the range of 0.45-0.55 V and typical current densities in the range of 4-9 mA cm⁻².

In all cases the devices were encapsulated using a transparent barrier foil for protection against the mechanical stress and atmospheric components.

The solar cells were blocked at different degrees, and the effect on the output effect at the maximum power point was measured. The results are shown in the below table.

If 1 percent of the solar cells were blocked, the output Pmpp was 0.89 compared to the output Pmpp when no solar cells were blocked. This is equivalent to a drop in the effect at the maximum power point of 11%.

Similarly, the drop in Pmpp was 36 percent when 5 percent of the cells were blocked, and 57 percent when 10 percent of the cells were blocked etc.

Had the solar cells - in contrast - been conventional solar cells, the drop in Pmpp had been 100 percent, if just one of the solar cells had been overshadowed. Accordingly, the use of foil-based solar cells (which are arranged in electrical series) results in generation of electrical energy even if some of the solar cells are blocked or overshadowed.

| Blocked | Impp | Vmpp | Pmpp | Pmpp loss | Std(Pmpp) % |
|---|---|---|---|---|---|
| 0% | 1 | 1 | 1.00 | 0% | 0 |
| 1% | 0.93 | 0.96 | 0.89 | 11% | 0.39 |
| 5% | 0.80 | 0.81 | 0.64 | 36% | 0.95 |
| 10% | 0.61 | 0.71 | 0.43 | 57% | 1.05 |
| 15% | 0.46 | 0.65 | 0.30 | 70% | 1.00 |
| 20% | 0.35 | 0.61 | 0.21 | 79% | 1.07 |
| 25% | 0.28 | 0.57 | 0.16 | 84% | 1.05 |

### BRIEF DESCRIPTION OF THE DRAWINGS

The invention will now be described in further details with reference to the accompanying figures, wherein
Fig. 1 shows a photovoltaic module comprising photovoltaic cells which are arranged in series,
Fig. 2 shows an electrical diagram of a photovoltaic module according to the present invention,
Fig. 3 shows IV-curves for crystalline-Si based solar cells,
Fig. 4 is a close-up of Fig. 3, and
Fig. 5 shows IV-curves for polymer-based solar cells.

While the invention is susceptible to various modifications and alternative forms, specific embodiments have been shown by way of examples in the drawings and will be described in detail herein. It should be understood, however, that the invention is not intended to be limited to the particular forms disclosed.

### DETAILED DESCRIPTION OF THE INVENTION

In its most general aspect the present invention relates to a foil-based photovoltaic module comprising a large number of series connected photovoltaic cells. The photovoltaic cells may advantageously be arranged in photovoltaic cell units. Typically, a photovoltaic installation comprising foil-based photovoltaic modules of the present invention will cover ground areas of several hundreds, or even several thousands, square meters.

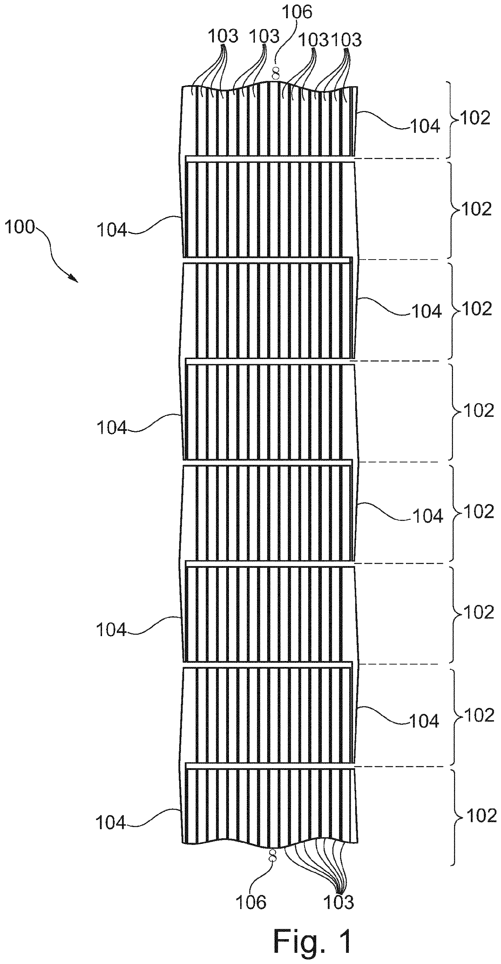

Fig. 1 shows a polymer-based photovoltaic module 100 comprising a carrier element 101 in the form of an organic polymer foil. On the carrier element is provided a plurality of photovoltaic cell units 102. Each photovoltaic cell unit comprises 16 photovoltaic cells 103 which are electrically connected in series. Moreover, the units are also electrically connected in series. In order to do this, each unit 102 comprises an end-photovoltaic cell 104 which is designed such that a part of it extends between the respective two photovoltaic cells. Although not visible in the figure, it will be appreciated that an interconnecting electrical conductor is provided between each of the photovoltaic cells which are electrically connected to each other. In the figure, these interconnecting electrical conductors are provided in the thin white spaces between the photo voltaic cells 103.

In Fig. 1, eight photovoltaic cells are provided, however due to the design of the solar cell, an unlimited number of photovoltaic cells may be provided as is indicated by infinity signs 106. Due to the topography of the photovoltaic module, it may be manufactured in an endless manner such that a user may simply cut the solar cell at a desired length and use the end cell as the positive module terminal 108 and as the negative module terminal 110.

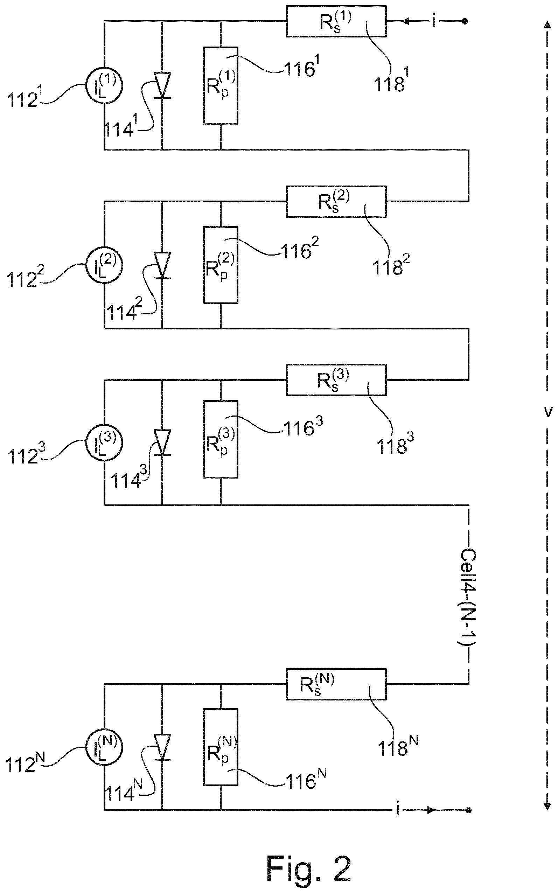

Fig. 2 shows an electrical diagram representing the polymer-based organic solar cell where N photovoltaic cells are connected in series. Electrically each photovoltaic cell may be modeled by a photocurrent generator I_{L} 112^{1,2,3,..N}, a diode 114^{1,2,3,..N} described by the Shockley diode equation in parallel with a shunt resistance Rₚ^{1,2,3,..N} 116^{1,2,3,..N}, and with a series resistance R_{S}^{1,2,3,..N} 118^{1,2,3,..N}.

For a set of series connected solar cells, each cell experiences a voltage drop. The voltage of the full set of solar cells is the sum of the voltage drops over each cell when the same current flows through the cell.

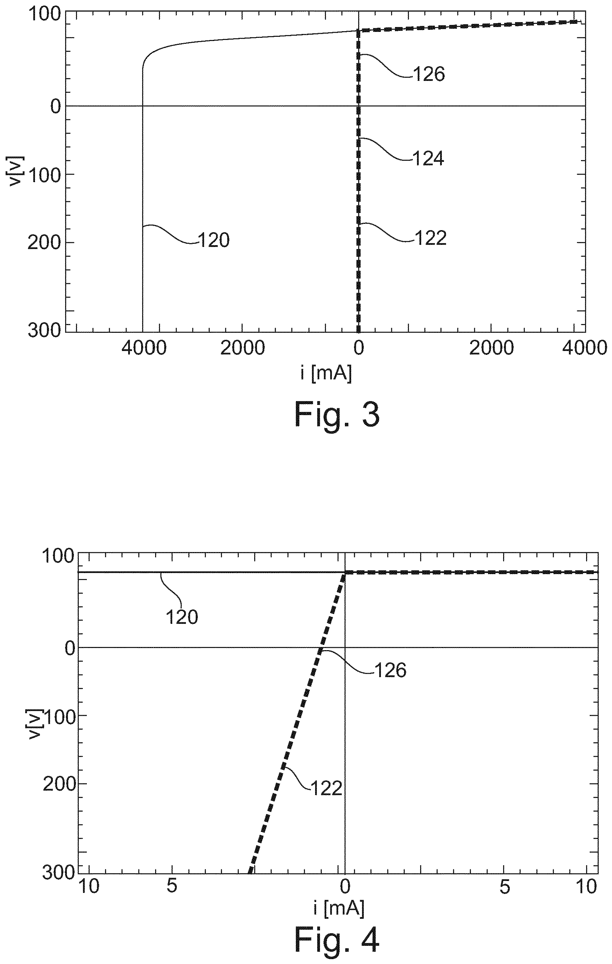

Figs. 3 and 4 show the IV-curves for a set of photovoltaic cells which are connected in electrical series. The x-axis corresponds to the current generated by the solar cell, and the y-axis corresponds to the voltage generated.

The figures are based on a model comprising 160 photovoltaic crystalline-Si based solar cells. The figure comprises two graphs a full curve and a dash-dotted curve. The full curve 120 corresponds to all 160 photovoltaic cells functioning and, thus, illustrates a conventional IV-curve for a solar cell. The dash-dotted curve 122 illustrates one of the 160 photovoltaic cells being blocked. It will be appreciated from the figure, that in the latter case, substantially no photo current is generated, as the current (I_{SC}) is decreased from approximately 4A to 2 mA when one cell is blocked. Fig. 4 is a close up of Fig. 3.

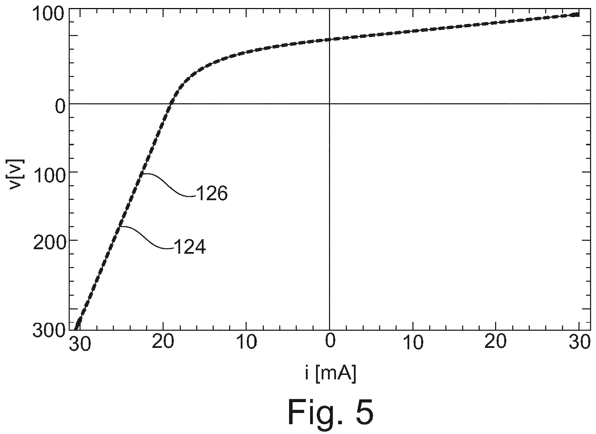

Fig. 5 illustrates the same setup, however with the difference that the solar cells are not crystalline-Si based solar cells but instead polymer-based solar cells. In Fig. 5, the parameters the photovoltaic cells vary up to 10 for each individual cell.

It will be appreciated, that the full curve 124 and the dash-dotted curve 126 coincide, which illustrates that even if one of the 160 photovoltaic cells is blocked, electrical effect is still generated.

In conclusion it will be realized that an advantage of the crystalline-Si based solar cells is their efficiency, which contrary to polymer-based solar cells is much higher. However, if only one of the photovoltaic cells is blocked, substantially no electrical power is generated.

Contrary hereto, the efficiency of organic solar cells is much lower, however this less efficient solar cells will still generate electricity, if the one or more of the solar cells is/are overshadowed.

## Claims

1. A photovoltaic module (100) comprising a carrier substrate, said carrier substrate carrying a purely printed structure comprising:
- a printed positive module terminal,
- a printed negative module terminal, and
- a plurality of printed photovoltaic cell units (102) each comprising one or more printed photovoltaic cells (103), wherein the plurality of printed photovoltaic cell units (102) are electrically connected in series between the positive and the negative module terminals such that any two neighbouring photovoltaic cell units (102) are electrically connected by a printed interconnecting electrical conductor (104),
**characterised in that** the carrier substrate comprises a foil, and wherein the total thickness of the photovoltaic module is below 500 µm and wherein the nominal voltage level between the positive and the negative terminals is at least 5 kV DC, and wherein the foil is of a bendable material having a bend radius below 50 mm.

2. A photovoltaic module (100) according to claim 1, wherein the plurality of printed photovoltaic cell units (102) each comprises a plurality of series connected printed photovoltaic cells (103).

3. A photovoltaic module (100) according to claim 1, wherein the plurality of printed photovoltaic cell units (102) each comprises a single printed photovoltaic cell.

4. A photovoltaic module (100) according to any of claims 1-3, wherein the nominal voltage level between the positive and the negative terminals is at least 6 kV DC, preferably at least 8 kV DC, preferably at least 10 kV DC.

5. A photovoltaic module (100) according to any of claims 1-4, wherein the number of series connected and printed photovoltaic cells is at least 5000 cells, preferably at least 10000 cells, preferably at least 15000 cells, preferably at least 20000 cells.

6. A photovoltaic module (100) according to any of claims 1-5, wherein the area of the module is at least 50 m², preferably at least 100 m², preferably at least 150 m², preferably at least 200 m² preferably at least 250 m².

7. A photovoltaic module (100) according to any of claims 1-6, wherein the photovoltaic module forms a structure that may be rolled up to form a roll.

8. A photovoltaic module (100) according to any of claims 1-7, wherein the photovoltaic module is an organic photovoltaic module.

9. A photovoltaic module (100) according to any of claims 1-8, wherein a height of each of the printed interconnecting electrical conductors (104), in a direction parallel to a normal of the foil, is below 100 µm.

10. A photovoltaic module (100) according to any of claims 1-9, wherein a cross-sectional area of each of the printed interconnecting electrical conductors (104) in a plane transverse to a longitudinal direction of the printed interconnecting electrical conductor is below 0.05
mm².

11. A photovoltaic module (100) according to any of claims 1-10, wherein the resistance of each of the printed interconnecting electrical conductors (104) is above 1 ohm.

12. A photovoltaic module (100) according to any of claims 1-11, wherein the number of photovoltaic cells per square meter is above 500.

13. A method for manufacturing an organic photovoltaic module according to claim (100) having a total thickness below 500 µm on a carrier substrate comprising a bendable foil, the method comprising the steps of:
- providing the foil as a roll of foil,
- printing a positive module terminal on the foil,
- printing a negative module terminal on the foil,
- printing a plurality of series connected photovoltaic cell units (102) on the foil, each photovoltaic cell unit (102) comprising one or more photovoltaic cells (103), the plurality of printed photovoltaic cell units (102) being electrically connected in series between the positive and the negative module terminals such that any two neighbouring photovoltaic cell units (102) are electrically connected by a printed interconnecting electrical conductor (104), and
- roll up the foil having organic photovoltaic modules printed thereon so that the foil forms a roll
**characterised in that** the bendable foil has a bend radius below 50 mm and wherein the nominal voltage level between the positive and the negative terminals is at least 5 kV DC

## Patentansprüche

1. Photovoltaisches Modul (100), umfassend ein Trägersubstrat, wobei das Trägersubstrat eine rein gedruckte Struktur trägt, umfassend:
- ein gedrucktes, positives Modulterminal,
- ein gedrucktes, negatives Modulterminal und
- mehrere gedruckte photovoltaische Zelleinheiten (102), von denen jede eine oder mehrere gedruckte photovoltaische Zelle(n) (103) umfasst, wobei die mehreren gedruckten, photovoltaischen Zelleinheiten (102) elektrisch in Serie zwischen dem positiven und dem negativen Terminalmodul derart angeschlossen sind, dass jegliche beliebigen zwei benachbarten photovoltaischen Zelleinheiten (102) durch einen gedruckten, elektrischen Interconnect-Leiter (104) elektrisch angeschlossen sind,
**dadurch gekennzeichnet, dass** das Trägersubstrat eine Folie umfasst und wobei die Gesamtdicke des photovoltaischen Moduls unter 500 µm beträgt und wobei das Nennspannungsniveau zwischen dem positiven und dem negativen Terminal wenigstens 5 kV Gleichstrom beträgt und wobei die Folie aus einem biegsamen Material mit einem Biegeradius von weniger als 50 mm besteht.

2. Photovoltaisches Modul (100) nach Anspruch 1, wobei die mehreren gedruckten, photovoltaischen Zelleinheiten (102) jeweils mehrere Serien umfassen, die an gedruckte, photovoltaische Zellen (103) angeschlossen sind.

3. Photovoltaisches Modul (100) nach Anspruch 1, wobei die mehreren gedruckten, photovoltaischen Zelleinheiten (102) jeweils eine einzelne gedruckte, photovoltaische Zelle umfassen.

4. Photovoltaisches Modul (100) nach irgendeinem der Ansprüche 1 bis 3, wobei das Nennspannungsniveau zwischen dem positiven und dem negativen Terminal wenigstens 6 kV Gleichstrom, bevorzugt 8 kV Gleichstrom, bevorzugt wenigstens 10 kV Gleichstrom beträgt.

5. Photovoltaisches Modul (100) nach irgendeinem der Ansprüche 1 bis 4, wobei die Anzahl von angeschlossenen und gedruckten photovoltaischen Zelleserien wenigstens 5.000 Zellen, bevorzugt wenigstens 10.000 Zellen, weiter bevorzugt wenigstens 15.000 Zellen, noch weiter bevorzugt wenigstens 20.000 Zellen beträgt.

6. Photovoltaisches Modul (100) nach irgendeinem der Ansprüche 1 bis 5, wobei der Bereich des Moduls wenigstens 50 m², bevorzugt wenigstens 100 m², weiter bevorzugt 150 m², noch weiter bevorzugt 200 m², noch weiter bevorzugt 250 m² beträgt.

7. Photovoltaisches Modul (100) nach irgendeinem der Ansprüche 1 bis 6, wobei das photovoltaische Modul eine Struktur formt, die zum Formen einer Rolle aufgerollt sein kann.

8. Photovoltaisches Modul (100) nach irgendeinem der Ansprüche 1 bis 7, wobei das photovoltaische Modul ein organisches photovoltaisches Modul ist.

9. Photovoltaisches Modul (100) nach irgendeinem der Ansprüche 1 bis 8, wobei eine Höhe jeder der gedruckten, elektrischen Interconnect-Leiter (104) in einer Richtung, die zur Normalen der Folie parallel ist, weniger als 100 µm beträgt.

10. Photovoltaisches Modul (100) nach irgendeinem der Ansprüche 1 bis 9, wobei ein Querschnittsbereich jeder der gedruckten, elektrischen Interconnect-Leiter (104) in einer Ebene, die zu einer Längsrichtung des gedruckten, elektrischen Interconnect-Leiters quer verläuft, weniger als 0,05 mm² beträgt.

11. Photovoltaisches Modul (100) nach irgendeinem der Ansprüche 1 bis 10, wobei der Widerstand jedes der gedruckten, elektrischen Interconnect-Leiter (104) mehr als 1 Ohm beträgt.

12. Photovoltaisches Modul (100) nach irgendeinem der Ansprüche 1 bis 11, wobei die Anzahl von photovoltaischen Zellen pro Quadratmeter mehr als 500 beträgt.

13. Verfahren zum Herstellen eines organischen photovoltaischen Moduls nach Anspruch 1 mit einer Gesamtdicke von weniger als 500 µm auf einem Trägersubstrat, umfassend eine biegsame Folie, wobei das Verfahren die Schritte umfasst:
- Bereitstellen der Folie als eine Rollenfolie,
- Drucken eines positiven Modulterminals auf der Folie,
- Drucken eines negativen Modulterminals auf der Folie,
- Drucken von mehreren angeschlossenen, photovoltaischen Zelleinheiten-Serien (102) auf der Folie, wobei jede photovoltaische Zelleinheit (102) eine oder mehrere photovoltaische Zelle(n) (103) umfasst, wobei die mehreren gedruckten, photovoltaischen Zelleinheiten (102) elektrisch in Serie zwischen dem positiven und dem negativen Modulterminal derart angeschlossen sind, dass jede zwei benachbarten photovoltaischen Zelleinheiten (102) elektrisch durch einen gedruckten, elektrischen Interconnect-Leiter (104) angeschlossen sind, und
- Aufrollen der Folie mit darauf aufgedruckten organischen, photovoltaischen Modulen derart, dass die Folie eine Rolle formt,
**dadurch gekennzeichnet, dass** die biegsame Folie einen Biegeradius von weniger als 50 mm aufweist und wobei das Nennspannungsniveau zwischen dem positiven und dem negativen Terminal 5 kV Gleichstrom beträgt.

## Revendications

1. Module photovoltaïque (100) comprenant un substrat porteur, ledit substrat porteur portant une structure purement imprimée comprenant :
- une borne de module positive imprimée,
- une borne de module négative imprimée, et
- une pluralité d'unités de cellules photovoltaïques imprimées (102) comprenant chacune une ou plusieurs cellules photovoltaïques imprimées (103), dans lequel la pluralité d'unités de cellules photovoltaïques imprimées (102) sont connectées électriquement en série entre les bornes positive et négative du module de telle sorte que deux éventuelles cellules photovoltaïques voisines (102) soient connectées électriquement par un conducteur électrique d'interconnexion imprimé (104),
**caractérisé en ce que** le substrat porteur comprend une feuille, et dans lequel l'épaisseur totale du module photovoltaïque est inférieure à 500 µm et dans lequel le niveau de tension nominale entre les bornes positive et négative est d'au moins 5 kV DC, et dans lequel la feuille est constituée d'un matériau pliable ayant un rayon de pliage inférieur à 50 mm.

2. Module photovoltaïque (100) selon la revendication 1, dans lequel la pluralité d'unités de cellules photovoltaïques imprimées (102) comprend chacune une pluralité de cellules photovoltaïques imprimées connectées en série (103).

3. Module photovoltaïque (100) selon la revendication 1, dans lequel la pluralité d'unités de cellules photovoltaïques (102) comprennent chacune une seule cellule photovoltaïque imprimée.

4. Module photovoltaïque (100) selon une quelconque des revendications 1 à 3, dans lequel le niveau de tension nominale entre les bornes positive et négative est d'au moins 6 kV DC, et de préférence d'au moins 8 kV DC, de préférence d'au moins 10 kV DC.

5. Module photovoltaïque (100) selon une quelconque des revendications 1 à 4, dans lequel le nombre de cellules photovoltaïques connectées en série et imprimées est d'au moins 5 000 cellules, de préférence au moins 10 000 cellules, de préférence au moins 15 000 cellules, de préférence au moins 20 000 cellules.

6. Module photovoltaïque (100) selon une quelconque des revendications 1 à 5, dans lequel la surface du module est d'au moins 50 m², de préférence au moins 100 m², de préférence au moins 150 m², de préférence au moins 200 m², de préférence au moins 250 m².

7. Module photovoltaïque (100) selon une quelconque des revendications 1 à 6, dans lequel le module photovoltaïque forme une structure qui peut être enroulée pour former un rouleau.

8. Module photovoltaïque (100) selon une quelconque des revendications 1 à 7, dans lequel le module photovoltaïque est un module photovoltaïque organique.

9. Module photovoltaïque (100) selon une quelconque des revendications 1 à 8, dans lequel une hauteur de chacun des conducteurs électriques d'interconnexion imprimés (104), dans une direction parallèle à une normale de la feuille, est inférieure à 100 µm.

10. Module photovoltaïque (100) selon une quelconque des revendications 1 à 9, dans lequel un périmètre de section transversale de chacun des conducteurs électriques d'interconnexion imprimés (104) dans un plan transversal à une direction longitudinale du conducteur électrique d'interconnexion imprimé est inférieur à 0,05 mm².

11. Module photovoltaïque (100) selon une quelconque des revendications 1 à 10, dans lequel la résistance de chacun des conducteurs électriques d'interconnexion imprimés (104) est supérieure à 1 ohm.

12. Module photovoltaïque (100) selon une quelconque des revendications 1 à 11, dans lequel le nombre de cellules photovoltaïques par mètre carré est supérieur à 500.

13. Procédé de fabrication d'un module photovoltaïque organique selon la revendication 1, ayant une épaisseur totale inférieure à 500 µm sur un substrat porteur comprenant une feuille pliable, le procédé comprenant les étapes consistant à :
- fournir la feuille sous forme de rouleau de feuille,
- imprimer une borne de module positive sur la feuille,
- imprimer une borne de module négative sur la feuille,
- imprimer une pluralité d'unités de cellules photovoltaïques connectées en série (102) sur la feuille, chaque unité de cellule photovoltaïque (102) comprenant une ou plusieurs cellules photovoltaïques (103), la pluralité d'unités de cellules photovoltaïques imprimées (102) étant électriquement connectée en série entre les bornes positive et négative du module de telle sorte que deux éventuelles cellules photovoltaïques voisines (102) soient connectées électriquement par un conducteur électrique d'interconnexion imprimé (104), et
- enrouler la feuille sur laquelle sont imprimés des modules photovoltaïques organiques de sorte que la feuille forme un rouleau,
**caractérisé en ce que** la feuille pliable a un rayon de courbure inférieur à 50 mm et dans lequel le niveau de tension nominale entre les bornes positive et négative est d'au moins 5 kV DC.
